Europäisches Patentamt

European Patent Office

Office européen des brevets

(11) Veröffentlichungsnummer: **0 001 429**
**B1**

(12) **EUROPÄISCHE PATENTSCHRIFT**

(45) Veröffentlichungstag der Patentschrift:
08.04.81

(21) Anmeldenummer: 78100986.5

(22) Anmeldetag: 25.09.78

(51) Int. Cl.³: **G 03 F 7/00**

(54) Verfahren zur Herstellung von Dünnfilmmustern unter Anwendung der Abhebetechnologie.

(30) Priorität: **29.09.77 US 837675**

(43) Veröffentlichungstag der Anmeldung:
**18.04.79 Patentblatt 79/8**

(45) Bekanntmachung des Hinweises auf die Patenterteilung:
**08.04.81 Patentblatt 81/14**

(84) Benannte Vertragsstaaten:
**DE FR GB**

(56) Entgegenhaltungen:
**SOLID STATE TECHNOLOGY, vol. 20, no. 8, August 1977, Washington, P. D. BLAIS: »Edge acuity and resolution in positive type photoresist systems«, Seiten 76—85.**
**IBM JOURNAL OF RESEARCH AND DEVELOPMENT, vol. 21, no. 3, May 1977, New York, F. H. DILL et al.: »Thermal effects on the photoresist AZ 135oJ«, Seiten 210—218.**
**IBM TECHNICAL DISCLOSURE BULLETIN, vol. 18, no. 5, Oktober 1975, New York,**
(73) Patentinhaber: **International Business Machines Corporation, Armonk, N.Y. 10504 (US)**

(72) Erfinder: **Dyer, Donald Raymond, 10 Scribo Road, Wappingers Falls New York 12590 (US)**
Erfinder: **Johnson, Jr., Claude, 2460 Pine Grove Court, Yorktown Heights New York 10598 (US)**
Erfinder: **Wilbarg, Robert Ronald, RR Nr.5,19 Fenwick Drive, Hopewell Junction New York 12533 (US)**

(74) Vertreter: **Kreidler, Eva-Maria, Dr. rer. nat., Schönaicher Strasse 220, D-7030 Böblingen (DE)**
**B. BERGIN et al., »Single layer optical lift-off process«, Seite 1395.**

## Verfahren zur Herstellung von Dünnfilmmustern unter Anwendung der Abhebetechnologie

Die Erfindung betrifft ein Verfahren zur Herstellung von Dünnfilmmustern unter Anwendung der Abhebetechnologie und insbesondere die Herstellung eines Dünnfilmmusters aus Metall bei der Herstellung integrierter Schaltkreise, bei dem
eine Schicht aus einem Positivphotoresist auf eine Unterlage aufgetragen,
durch Erhitzen gehärtet und
nach dem bildmäßigen Belichten
mit einem Entwickler entwickelt wird unter Ausbildung von Öffnungen, die an der der Unterlage anliegenden Oberfläche weiter sind als an der der Unterlage abgewandten Oberfläche und
bei dem ein Dünnfilm unter Verwendung der Photoresistmaske als Abscheidungsmaske auf der Unterlage abgeschieden und
die Photoresistmaske nach Abscheidung des Dünnfilms entfernt wird.

Bei den meisten der gegenwärtig bekannten Verfahren zur Herstellung metallischer Dünnfilmmuster durch Vakuumabscheidung wird ein Ätzverfahren in Gegenwart ätzbeständiger Photoresistschichten angewendet, um die gewünschten Muster zu erhalten. Dabei wird der übliche photolithographische Ätzprozeß angewendet. Mit zunehmender Miniaturisierung integrierter Schaltkreise, mit der eine größere Komponentendichte und kleinere Einheiten bei hochintegrierten Schaltkreisen erhalten werden sollen, kommt man bald zu der Grenze, ab der die photolithographischen Ätzprozesse, die an den abgeschiedenen Filmen durchgeführt werden, nicht mehr ausreichend sind, um die hohe Auflösung für feine Linienmuster der Metallisierung, insbesondere bei Metalldicken in der Größenordnung von 800 bis 2500 nm, die in solchen hochintegrierten Schaltkreisen angewendet werden, zu erhalten.

Alternativmethoden zur Herstellung der Metallisierung integrierter Schaltkreise hoher Dichte, welche derzeit diskutiert und angewendet werden, sind modifizierte Lift-off-Prozesse. Die folgenden Literaturstellen beschreiben unter anderem diese bekannten Verfahrensarten:

1. T. D. Schlabach u. a., »Printed and Integrated Circuitry«, Seiten 343 – 352, McGraw-Hill, New York, 1963,
2. K. C. Hu, »Expendable Mask: A New Technique for Patterning Evaporated Metal Films«, Electron Packaging and Production, Oktober 1967, Seiten 84 – 94,
3. M. Hatzakis, »Electron Resist for Micro-Circuit and Mask Production«, Journal of The Electrochemical Society, Bd. 116, Seite 1033, 1969,
4. H. I. Smith u. a., »A High-Yield Photolithographic Technique for Surface Wave Devices«, Journal of The Electrochemical Society, Bd. 118, Seite 821, 1971.

In den US-Patentschriften 3 849 136 und 3 982 943 wird ein Abhebeverfahren und eine Anordnung zum Aufbringen von Dünnfilmen beschrieben, mit denen das Kantenabrißproblem beim Abheben vermieden werden kann, indem Abscheidungsmasken mit Öffnungen, welche eine negative Steigung oder einen Überhang aufweisen, verwendet werden. Wegen dieser negativen Steigung wird das Kantenabrißproblem bei der Entfernung des restlichen Photoresists in einem üblichen Abhebeverfahren auf ein Minimum reduziert, wenn Dünnfilme, insbesondere Metallfilme auf der Anordnung abgeschieden werden. In beiden Patentschriften werden geeignete Verfahren zur Herstellung von Abscheidungsmasken mit negativer Steigung beschrieben. Es muß jedoch eine Anzahl von Abscheidungs- und Ätzschritten durchgeführt werden, um die Abscheidungsmaske mit dem gewünschten Überhang zu erzeugen.

Aus IBM Techn. Discl. Bull., Vol. 18, Nr. 5, Okt. 1975, S. 1395, ist ein Abhebeverfahren bekannt, bei dem auf eine Resistschicht nach der bildmäßigen Belichtung die Lösung eines Radikale bildenden Initiators, beispielsweise Benzoylperoxid in Benzol aufgetragen wird. Durch Erhitzen der Schicht wird der Initiator aktiviert, und es findet eine Vernetzung in den oberen Bereichen der Resistschicht statt. Bei der nachfolgenden Entwicklung werden die vernetzten Bereiche der Schicht langsamer entwickelt als die darunterliegenden, so daß eine Abscheidungsmaske mit negativer Steigung oder Überhang erhalten wird. Nachteilig an diesem Verfahren ist, daß ein separater Prozeßschritt zum Auftragen der Initiatorlösung erforderlich ist. Auch wird eine etwas niedrigere Auflösung des Musters als bei dem erfindungsgemäßen Verfahren erhalten.

Aus IBM J. Res. Develop., Mai 1977, S. 212 – 218, F. H. Dill und J. M. Shaw: »Thermal Effects on the Photoresist AZ 1350J«, ist bekannt, daß durch Einwirkung von Hitze Oberflächeneffekte in der Resistschicht auftreten können, die einen wesentlichen Einfluß auf die Resistentwicklung und die resultierenden Bildprofile haben, indem eine bei höheren Temperaturen gehärtete Photoresistschicht in den der freien Oberflächen nahen Bereichen langsamer entwickelt wird, wodurch bedeutend steilere Linienrandprofile erhalten werden. In dieser Veröffentlichung sind jedoch keine Angaben zur Erzeugung der für das Metallabhebeverfahren günstigen negativen Photoresistprofile enthalten.

Aufgabe der Erfindung ist, ein Verfahren zur Herstellung von Dünnfilmmustern unter Anwendung der Abhebetechnologie anzugeben, bei dem die Abscheidungsmaske mit Öffnungen, welche die gewünschte negative Steigung aufweisen, auf einfache Weise und mit hoher Ausbeute hergestellt wird.

Die Aufgabe der Erfindung wird gelöst durch ein Verfahren der eingangs genannten Art, das dadurch gekennzeichnet ist, daß die Photoresistschicht vor dem bildmäßigen Belichten teilgehärtet wird, wobei die der Unterlage abgewandte freie Oberfläche der Photoresistschicht 30 bis 60 Sekunden lang auf 120 bis 160°C erhitzt und die der Unterlage anliegende Oberfläche auf einer um wenigstens 40°C niedrigeren Temperatur gehalten wird.

Das Wesentlichste an der Erfindung ist die Teilhärtung der Photoresistschicht durch unterschiedliches Erhitzen, indem die der Unterlage anliegende Oberfläche der Photoresistschicht auf einer um wenigstens 40°C niedrigeren Temperatur gehalten wird als die der Unterlage abgewandte Oberfläche. Auf diese Art wird die der Unterlage abgewandte, belichtete Oberfläche der Photoresistschicht gezielt in stärkerem Maße gehärtet als die an der Unterlage anliegende Oberfläche der Photoresistschicht. Als Folge davon wird nach der Belichtung und während der Entwicklung der weniger gehärtete Teil der Photoresistschicht in stärkerem Maße entfernt als die in höherem Maße gehärtete belichtete Oberfläche der Photoresistschicht, wodurch ein Muster mit Öffnungen mit negativer Steigung erhalten wird, d. h. die Öffnungen weisen einen kleineren Durchmesser an der belichteten Oberfläche der Photoresistschicht auf als an der der Unterlage anliegenden Oberfläche, und als Ergebnis wird der Überhang, der in allen Abhebeverfahren entscheidend ist, erhalten.

Die Erfindung wird anhand der nachfolgenden Figuren und der speziellen Beschreibung näher erläutert.

Die Fig. 1A bis 1F stellen Querschnitte durch die Strukturen, die erfindungsgemäß hergestellt werden, dar. Außerdem ist ein Fließschema angegeben, das jeden einzelnen dieser Schritte erläutert.

Fig. 2 ist ein Schnitt durch eine Vorrichtung zur Durchführung des unterschiedlichen Erhitzens gemäß der Erfindung.

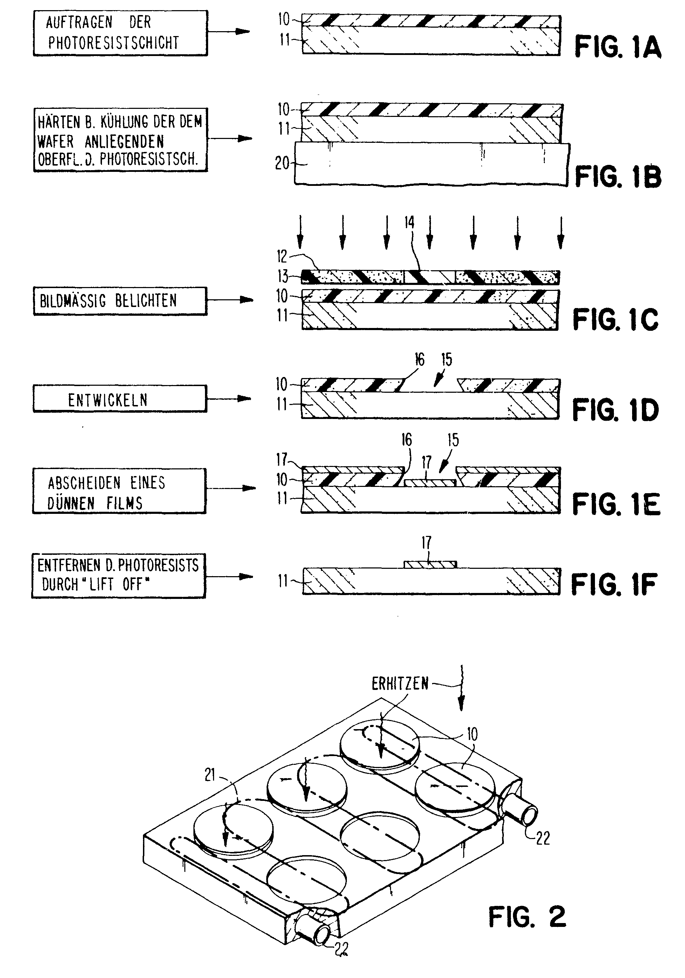

Die Fig. 1A bis 1F zeigen die Herstellung einer Maske nach dem erfindungsgemäßen Verfahren und die Verwendung dieser Maske in einem Abhebeverfahren. Gemäß Fig. 1A wird eine Photoresistschicht 10 auf einer Halbleiterunterlage 11 gebildet. Bei der Herstellung integrierter Schaltkreise kann die Unterlage 11 aus halbleitendem Material bestehen oder aus einem Halbleitersubstrat, welches mit einer elektrisch isolierenden Schicht, beispielsweise aus Siliciumdioxid oder Siliciumnitrid bedeckt ist. Schicht 10 besteht aus einem Positivphotoresistmaterial, das beispielsweise in der US-Patentschrift 3 666 473 beschrieben ist. Andere Photoresistmaterialien, beispielsweise solche, die in der US-Patentschrift 3 201 239 beschrieben sind, können auch zur Bildung der Schicht 10 gemäß der vorliegenden Erfindung verwendet werden. Die Photoresistzusammensetzung wird auf die Unterlage 11 durch ein konventionelles Schleuderbeschichtungsverfahren bei etwa 4000 Umdrehungen pro Minute aufgetragen.

Anschließend wird der Photoresist (Fig. 1B) unter den nachfolgenden angegebenen Bedingungen gehärtet. Unter Bezugnahme auf Fig. 2 werden die Wafer, auf die die Photoresistschicht 11 aufgetragen ist, in einer Vorrichtung befestigt, in der die Photoresistschicht auf der Halbleiterunterlage oder Waferoberfläche von oben erwärmt wird, während die andere Oberfläche des Wafers auf einer Kühlvorrichtung 20 angeordnet wird. Im allgemeinen wird eine Anzahl der Wafer in Vertiefungen 21 in der Kühlvorrichtung 20 angeordnet. Um das Temperaturgefälle in dem Photoresistüberzug 11 auf den Wafern während des Erhitzens der Wafer, beispielsweise in einem Ofen, aufrechtzuerhalten, wird die Kühlvorrichtung 20, welche aus einem wärmeleitenden Material, beispielsweise aus Metall hergestellt wird, in bekannter Weise gekühlt, beispielsweise durch eine Flüssigkeit, die durch die Schlangen 22 eines Flüssigkühlsystems zirkuliert. Thermoelektrisches Kühlen kann auch angewendet werden.

Um den Photoresistüberzug 10 teilweise in der Weise zu härten, daß die freiliegende Oberfläche der Photoresistschicht 10 stärker gehärtet ist als die untere Oberfläche des Überzugs 10, die der Unterlage anliegt, sollte die Dauer des Erhitzens oder Härtens relativ kurz sein, d. h. vorzugsweise in der Größenordnung von 40 bis 60 Sekunden verglichen mit dem konventionellen Photoresistvorhärten oder vorbereitenden Härtungszyklen, die etwa 5 bis 30 Minuten dauern. Bei einer länger dauernden Härtung wird es immer schwieriger, den Temperaturunterschied zwischen der oberen und der unteren Oberfläche der Photoresistschicht 10 aufrechtzuerhalten, was für das erfindungsgemäße Verfahren notwendig ist. Die besten Ergebnisse werden erhalten, wenn bei Anwendung einer Vorrichtung gemäß Fig. 2 die mit dem Photoresist beschichteten Wafer bei einer Temperatur von 120 bis 160°C und vorzugsweise bei etwa 140°C etwa 30 bis 60 Sekunden, vorzugsweise 40 Sekunden lang gehärtet werden, während die Unterseite des Wafers auf einer niedrigeren Temperatur gehalten wird. Bei einer geeigneten Temperaturwahl sollte die untere, oder der Unterlage anliegende Oberfläche der Photoresistschicht 10 auf einer Temperatur, die wenigstens 40° niedriger als die Temperatur der freiliegenden Oberfläche der Photoresistschicht ist, gehalten werden. Als Ergebnis dieser unterschiedlichen Härtung (Fig. 1B) wird die Photoresistschicht 10, die in diesem Ausführungsbeispiel eine Dicke von etwa 2 μ aufweist, teilweise gehärtet und unter Erhalt eines unterschiedlichen Härtungsgrades, wobei der Photoresist an der oberen Oberfläche der Schicht 10 stärker gehärtet wird als die Oberfläche des Photoresists, die der Unterlage 11 anliegt.

Anschließend wird die Struktur, wie in Fig. 1C gezeigt ist, mit einer Maske 12 mit durchsichtigen Bereichen 14 und undurchsichtigen Bereichen 13 bedeckt. In der Darstellung ist die Maske lediglich aus Gründen der Übersichtlichkeit in einem geringen Abstand von der Oberfläche dargestellt. Die Belichtung erfolgt mit einer 200-Watt-Quecksilberlampe für etwa 10 Sekunden. Als Ergebnis dieser Belichtung wird der Bereich der Photoresistschicht 10 unter dem durchsichtigen Bereich 14 löslich. Das Ausmaß der Löslichkeit hängt natürlich von dem Grad ab, zu dem die Photoresistschicht bei dem zuvor beschriebenen Erhitzen teilweise gehärtet wurde.

Dann wird die Struktur (Fig. 1D) entwickelt unter Anwendung eines üblichen alkalischen Entwicklers für Positivresistmaterialien, d. h. unter Anwendung einer 2,5gew.-%igen wäßrigen Lösung einer Mischung von Natriummetasilikat und Natriumphosphat, das überwiegend als Natriumorthophosphat vorliegt, mit einem pH-Wert bei Zimmertemperatur in der Größenordnung von 12,55. Die Entwicklung dauert etwa 30 Sekunden. Dabei werden Öffnungen 15 durch die Photoresistschicht 10 in einem Muster gebildet, das den durchsichtigen Bereichen 14 in der Maske 12 entspricht. Jede der Öffnungen weist eine negative Steigung auf, weil das Photoresistmaterial an der Unterseite der Öffnungen nicht so stark gehärtet wurde wie das Material in dem oberen Teil und daher das Photoresistmaterial bei der Belichtung gemäß Schritt 1C in dem unteren Teil stärker löslich gemacht wird als im oberen. Auf diese Weise hat der Photoresist, der die Öffnung 15 definiert, den Überhang 16, der für ein zufriedenstellendes Abheben erforderlich ist.

Anschließend wird gemäß Fig. 1E unter Verwendung der Photoresistschicht 10 als Abscheidungsmaske auf der Unterlage ein Metallfilm 17 bei einer Temperatur zwischen Zimmertemperatur und 100° C abgeschieden. Andererseits kann die Schicht 17 auch aus einem anorganischen, elektrisch isolierenden Material wie Siliciumdioxid oder Siliciumnitrid bestehen. Die isolierenden Materialien können in einem üblichen Kathodenzerstäubungsverfahren abgeschieden werden. In dem gezeigten Beispiel wird ein Metallfilm verwendet. Das Metall kann irgendeines der Metalle sein, die üblicherweise zur Metallisierung integrierter Schaltkreise verwendet werden, beispielsweise Aluminium-Kupferlegierungen, Platin, Palladium, Chrom, Silber, Tantal, Gold und Titan oder Mischungen derselben. Der Metallfilm 16 weist eine Dicke in der Größenordnung von 1 µ auf.

Anschließend wird (Fig. 1F) unter Anwendung des bekannten Lift-off-Verfahrens die Photoresistmaske 10 durch Eintauchen in ein Lösungsmittel wie N-Methylpyrrolidon, welches zur Entfernung von Photoresistmaterialien üblich ist, vollständig entfernt. Die Einwirkungszeit beträgt etwa 10 Minuten unter Anwendung von Ultraschallrühren. Es wird ein Dünnfilm aus Metall 17 in dem gewünschten und vorher bestimmten Muster erhalten. Das Lösungsmittel sollte so ausgewählt werden, daß es das Polymermaterial der Schicht 10 löst oder zum Quellen bringt, ohne daß der dünne Metallfilm 17 nachteilig beeinflußt wird. Als Lösungsmittel sind auch Aceton, Butylacetat, Trichloräthylen und Äthylglykolacetat geeignet.

Es soll hervorgehoben werden, daß der Ausdruck Dünnfilm, der in der vorliegenden Beschreibung verwendet wird, nicht eine bestimmte Filmdicke definiert, sondern sich auf die Dünnfilmtechnologie bezieht.

**Patentansprüche**

1. Verfahren zur Herstellung von Dünnfilmmustern unter Anwendung der Abhebetechnologie, bei dem
eine Schicht aus einem Positivphotoresist auf eine Unterlage aufgetragen,
durch Erhitzen gehärtet und
nach dem bildmäßigen Belichten
mit einem Entwickler entwickelt wird unter Ausbildung von Öffnungen, die an der der Unterlage anliegenden Oberfläche weiter sind als an der der Unterlage abgewandten Oberfläche und
bei dem ein Dünnfilm unter Verwendung der Photoresistmaske als Abscheidungsmaske auf der Unterlage abgeschieden und
die Photoresistmaske nach Abscheidung des Dünnfilms entfernt wird, dadurch gekennzeichnet, daß die Photoresistschicht vor dem bildmäßigen Belichten teilgehärtet wird, wobei die der Unterlage abgewandte freie Oberfläche der Photoresistschicht 30 bis 60 Sekunden lang auf 120 bis 160° C erhitzt und die der Unterlage anliegende Oberfläche auf einer um wenigstens 40° C niedrigeren Temperatur gehalten wird.

2. Verfahren nach Anspruch 1, dadurch gekennzeichnet, daß als Unterlage ein Halbleiterwafer mit integrierten Schaltungen, der mit einer isolierenden Schicht bedeckt ist, verwendet wird.

3. Verfahren nach Anspruch 1, dadurch gekennzeichnet, daß als Dünnfilm ein Metallfilm abgeschieden wird.

**Claims**

1. Method of making thin film patterns using the lift-off technique, where a layer of a positive photoresist is applied on a substrate, cured by heating, and after imagewise exposure developed with a developer forming apertures which at the surface facing against the substrate are wider than at the surface facing away from the substrate, and where a thin film is deposited on the substrate using the photoresist mask as a deposition mask, and where the photoresist mask is removed after the deposition of the thin film, characterized in that the photoresist layer is partially cured prior to the imagewise exposure, the free surface of the photoresist layer facing away from the substrate being heated for 30 to 60 sec. to 120 to 160°C, and the surface facing the substrate is maintained at least 40°C below said temperature.

2. Method as claimed in claim 1, characterized in that as a substrate a semiconductor wafer with integrated circuits covered with an insulating layer is used.

3. Method as claimed in claim 1, characterized in that as a thin film a metallic film is deposited.

## Revendications

1. Procédé pour fabriquer des configurations en pellicules minces en utilisant la technique d'élimination par décollement, dans lequel une couche de résine photo-sensible positive est déposée sur un support, durcie par un traitement thermique, et, après exposition à l'image, développée à l'aide d'un révélateur pour former des ouvertures qui sont, à la surface adjacente au support, plus larges qu'à la surface opposée, et dans lequel une pellicule mince est déposée sur le support à l'aide d'un masque de résine photo-sensible servant de masque de dépôt, et dans lequel le masque de résine photo-sensible est enlevé le dépôt de la pellicule mince, caractérisé en ce que la couche de résine photo-sensible est partiellement durcie avant exposition, la surface opposée au support de la couche photo-résistive, étant chauffée pendant 30 à 60 secondes à une température allant de 120 à 160°C alors que la surface adjacente au support est maintenue à une température inférieure d'au moins 40°C.

2. Procédé selon la revendication 1, caractérisé en ce qu'une tranche semi-conductrice avec des circuits intégrés, recouverte d'une couche isolante, est utilisée comme support.

3. Procédé selon la revendication 1, caractérisé en ce que la pellicule mince déposée est une pellicule métallique.

| AUFTRAGEN DER PHOTORESISTSCHICHT | → | **FIG. 1A** |

10
11

| HÄRTEN B. KÜHLUNG DER DEM WAFER ANLIEGENDEN OBERFL. D. PHOTORESISTSCH. | → | **FIG. 1B** |

10
11
20

14

| BILDMÄSSIG BELICHTEN | → | **FIG. 1C** |

12
13
10
11

| ENTWICKELN | → | **FIG. 1D** |

16  15
10
11

| ABSCHEIDEN EINES DÜNNEN FILMS | → | **FIG. 1E** |

16  15
17
10
17
11

| ENTFERNEN D. PHOTORESISTS DURCH "LIFT OFF" | → | **FIG. 1F** |

17
11

ERHITZEN

21
10
22
22

**FIG. 2**

7